Europäisches Patentamt

European Patent Office

Office européen des brevets

(19)

(11) Publication number: **0 026 297**
**B1**

(12) **EUROPEAN PATENT SPECIFICATION**

(45) Date of publication of patent specification: **21.09.83**

(51) Int. Cl.³: **G 01 R 31/02**

(21) Application number: **80104606.1**

(22) Date of filing: **05.08.80**

(54) **Apparatus for sensing and locating shorts between a plurality n of electrical conductors.**

(30) Priority: **24.08.79 US 69485**

(43) Date of publication of application:
**08.04.81 Bulletin 81/14**

(45) Publication of the grant of the patent:
**21.09.83 Bulletin 83/38**

(84) Designated Contracting States:
**CH DE FR GB LI NL SE**

(56) References cited:
**DD - A - 80 772**
**DE - B - 1 953 785**
**DE - C - 1 001 412**
**US - A - 2 814 774**
**US - A - 3 480 856**
**US - A - 3 879 662**

**Patents Abstracts of Japan Vol. 1, No. 148, 29
November 1977 page 7609E77**

(73) Proprietor: **NATIONAL AERONAUTICS AND
SPACE ADMINISTRATION**
**NASA Headquarters**
**Washington, D.C. 20546 (US)**

(72) Inventor: **Deboo, Gordon J.**
**165 Jacinto Way**
**Sunnyvale, California 94086 (US)**
Inventor: **Devine, David Joseph**
**4914 McCoy Avenue**
**San Jose California 95130 (US)**

(74) Representative: **Lehn, Werner, Dipl.-Ing. et al,
Hoffmann, Eitle & Partner Patentanwälte
Arabellastrasse 4 (Sternhaus)
D-8000 München 81 (DE)**

Courier Press, Leamington Spa, England

# Apparatus for sensing and locating shorts between a plurality n of electrical conductors

The present invention relates to apparatus for sensing and locating shorts between a plurality n of insulated electrical conductors, said apparatus comprising:

a plurality n of resistors;

means for connecting a single electrode of each resistor to a different one of said electrical conductors;

sequencing means for sequentially energising said resistors;

an alarm; and

means for sensing the electric current passing through all of said resistors and for turning on said alarm and terminating said sequential energisation when a predetermined current level is exceeded.

In complex electrical systems such as computers, it is common to use power and grounding bus bars or rails. Often these bars have hundreds or even thousands of wires connected thereto. After the wires are attached to the bus bars and the circuits are inspected, shorts are invariably discovered, especially when the terminals are closely spaced. It is very difficult and time consuming to detect these wiring errors. If the system is energized before shorts are removed, components in the system can be damaged.

In the past, searches for shorts were normally conducted after the electrical equipment was completed, not during the actual assembly process. Often an ohmmeter was used to hunt for shorts.

Some test instruments have been designed to detect shorts in assembled cables. They require a connector for each end of the cable under test and they utilize complex circuits, slow unreliable mechanical switching devices, or high voltages. Representative cable testing devices are disclosed in US—A—2 814 774, US—A—3 480 856, US—A—4 015 200, DE—C—1 001 412, DE—A—80772, DE—B—1 953 785, Patents Abstract of Japan Vol. 1, No. 148, 29 November 1977, page 7609E77 and JP—A—52—87684.

US—A—3 713 019 describes an apparatus for sequentially examining points in an electrical matrix so as to detect failures in components such as transistors. A transformer is required at every sensing station, and the switching is accomplished with relays.

In particular DE—C—1 001 412 describes a circuit arrangement for automatically and sequentially examining the insulation between electrically insulated conductors. This known circuit arrangement comprises several electrical lamps serially connected to a relay, wherein this serial connection is connected at the one end to a respective conductor to be tested, whereas the other terminal of this serial connection is connected to one terminal (earth) of a DC-power supply. The one terminal of the serial connection including at least one lamp and one relay can be connected to the other terminal of the power supply and the corresponding relay is excited if no short circuit is present between the corresponding conductor and another conductor to earth. If the relay of a first serial connection is excited, an associated contact of the next following serial connection will be switched over so that the next following serial connection becomes active and so on until the last serial connection corresponding to the last conductor to be tested is switched into the power supply circuit. If a short circuit is present between two conductors under test, then the associated relays are no more supplied with a sufficient high voltage and the automatic switching on is interrupted indicating a short circuit. Thus with this known circuit arrangement the testing process is automatically stopped, if an insulation error is detected between two insulated conductors under test. However, this known circuit arrangement can only be operated with relatively high voltages and can also not be adapted or adjusted to predetermined insulation impedances.

DE—B—1 953 785 describes a method for sensing short circuits between electrical conductors according to which method the conductors to be tested are connected to the one end of a resistor, the other terminals of which resistors being connected together. This common terminal is an input to an analogue adder circuit, the output of which is connected to a voltage measuring device. Each one of the conductors under test is sequentially supplied with DC-voltage and for sensing and locating a short circuit a table including special information must be used.

In US—A—2 814 774 an electrical continuity and short tester for selectively testing and indicating shorts between a plurality of conductors of a multiple conductor cable is described. The tester comprises a first plurality of normally conducting gaseous discharged devices including one device for each conductor of the cable to be tested, a potential source for supplying voltage to each device and a first plurality of resistors connected in series with each of said devices for limiting the current flowing therethrough when said devices are conducting. The discharge devices are connected through capacitors to the respective conductors and if there is a short circuit between at least two conductors, the associated discharge devices are alternately switched on and out indicating the short circuit between the associated conductors. This short tester must also be operated with relatively high voltage and there is also no possibility to adjust this short tester to individual short circuit impedances.

From US—A—3 480 856 a continuity, short and transposition tester for multiwire cable is known having a series loop of resistances, one for each wire, and a series connection of test indicators bridging the loop and each bridging an individual resistor through a wire of the cable under test. The test indicators are simultaneously excited if no short circuit is sensed and therefore this known tester has high power consumption.

The tester known from DD—A—80772 comprises an electronic binary counter which is continuously controlling a device to be tested. However, according to this circuit arrangement the two ends of a conductor to be tested must be connected to the circuit.

Inasmuch as it is cost effective to locate electrical shorts as they occur during the assembly process of complex bus bar circuits, it is an object of this invention to provide an instrument that generates an audible warning as soon as a shorting-type wiring error is made, and gives a visual indication of the actual bus bars that have erroneously been brought together in electrical contact. According to the invention, the apparatus defined in the introductory paragraph of this specification is characterised in that said resistors are respective electric lamps; in that said sequencing means comprises pulse generator means for generating pulses at a predetermined rate, means having an input coupled to the output of said pulse generator means and n outputs for sequentially emitting pulses at said predetermined rate, and coupling means arranged sequentially to couple the n outputs to respective first terminals of said electric lamps; in that said sensing means comprises a resistor connected between ground and second terminals of said electric lamps, a comparator having first and second inputs and an output the first input being connected to the second terminals of said electric lamps, means for producing a fixed reference voltage and applying it to said second input of the comparator, and means coupled to said output of said comparator and connected to turn on said alarm for a predetermined period and to switch off said pulse generating means when the voltage at said first input of the comparator exceeds said reference voltage; and in that said alarm is a sonic alarm, whereby said pulses from said pulse generator means cause in operation said lamps to be sequentially energised at said predetermined rate and a maximum voltage V to be produced across said resistor when no conductors are shorted together so that when said reference voltage is set slightly higher than V a short condition between at least two of said conductors will cause said voltage across said resistor to exceed said reference voltage whereby said comparator will respond to cause said pulse generating means to stop generating pulses, to cause said alarm to sound for said predetermined period, and to cause those electric lamps associated with the shorted conductors to remain illuminated until the short condition is removed.

Apparatus according to the present invention may thus be designed for automatically detecting and locating short circuits as they occur while an electrical system is being fabricated. Briefly, the invention provides an alarm and means for sensing the electric current passing through all of said electric lamps and simultaneously turning on said alarm and terminating said sequential energisation when a predetermined current level is exceeded, whereby two electric lamps remain illuminated and said two lamps are indicative of the conductors that are shorted.

Said means for sequentially emitting pulses preferably comprises a ring counter having an input and a plurality of outputs.

Briefly the electrical short locator in accordance with the invention requires only a single connection to each conductor (e.g. a bus bar) under test. A light emitting diode can be provided as lamp for each bus bar, rail or other electrical conductor to be tested. Each diode is serially connected to a bipolar transistor and the transistors are normally sequentially activated. The current through the transistors and diodes passes through a common resistor. When a short occurs, the voltage drop sensed across the resistor triggers a sonic alarm and stops the sequential activation of the light emitting diodes. The diodes corresponding to the shorted bus bars remain illuminated·until the short is removed.

It will be apparent that the invention is particularly suitable for sensing and locating shorts established between any two or more of a plurality of electrical bus bars, insulated from one another in an array, during the connection of electrical leads to contact pins of the bus bars.

*Brief Description of the Drawings*

Figure 1 is a schematic diagram of an electrical short locator circuit in accordance with the principles of the invention.

Figure 2 is a perspective view of a bus bar assembly that may be tested with the electrical short locator.

*Description of the Preferred Embodiment*

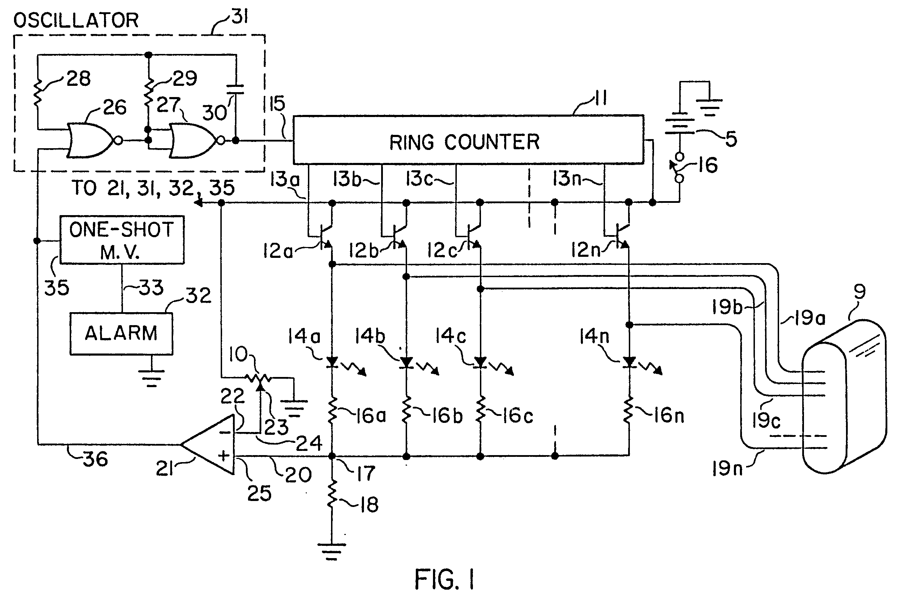

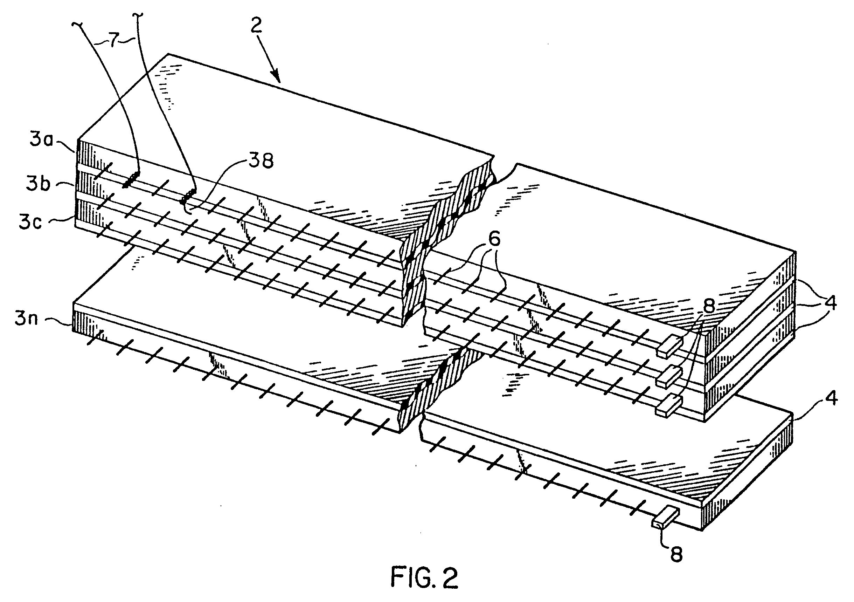

Referring to the drawings, the electrical short locator is shown in Fig. 1 and a typical bus bar assembly 2 on which the locator may be employed is depicted in Fig. 2. Bus bars 3a, 3b, 3c, 3n are separated from each other by electrical insulators 4. Pin-like terminals 6 are affixed to each of the bus bars, and electrical leads 7 are connected to the terminals by conventional solder or wire-wrap techniques. Each bus bar 3a—3n has a plug 8. These plugs typically are used to connect bus bars to remote circuits such as power sources. Socket 9 (shown in Fig. 1) mates with plugs 8 and it enables the electrical short locator to be brought into electrical communication with the bus bars.

The bases of bipolar transistors 12a, 12b, 12c and 12n are connected to the outputs of ring counter 11 by leads 13a, 13b, 13c and 13n. Ring counter 11 may be, for example, single or cascaded CMOS 4017's or 4022's. The collectors of the transistors are commonly joined between one fixed terminal of potentiometer 10 and SPST switch 16. The other terminal of switch 16 is connected to a d-c power supply 5. The emitters of the NPN transistors 12a, 12b, 12c, 12n are connected to the anodes of light emitting diodes, LED's, 14a, 14b, 14c, 14n, respectively. Resistors 16a, 16b, 16c, 16n, are connected between the cathodes of the LED's and node 17. Resistor 18 is coupled between node 17 and ground. Conductors or leads 19a, 19b, 19c, 19n extend from the emitters of transistors 12a—12n to socket 9. The conductors are so arranged within the socket so that when it is connected with plugs 8, conductor 19a makes electrical contact with the second-from-the-top plug, and so forth. Conductors 19a—19n need not terminate in a socket. If desired, each conductor may terminate in a test clip such as an alligator clip. The clips may be fastened to a terminal on the bus or to the bus bar itself.

A comparator 21 has a first input 22 coupled to wiper 23 of potentiometer 10 by lead 24. The second input 25 of comparator 21 is connected to node 17 via lead 20.

Nor gates 26 and 27 are interconnected with resistors 28, 29 and capacitor 30 to form a squarewave oscillator 31. For example, a waveform with a frequency of 1 Hz is generated when resistors 28 and 29 are 1 M$\Omega$ and 390 K$\Omega$, respectively, and capacitor 30 has a value of 0.22 $\mu$F. The clock pulses for ring counter 11 are provided by oscillator 31 and carried to the counter on conductor 15. Alarm 32 is coupled to a one-shot multivibrator 35 by means of lead 33. When a pulse, preferably with a period of at least five seconds, is released from one-shot multivibrator 35, sound is produced from alarm 32 for the duration of the pulse. Alarm 32 may be a bell, a buzzer, or a piezoelectric sounder such as the Sonalert (TM) manufactured by Mallory. The output of comparator 21 is coupled to the input of multivibrator 35 and one input of NOR gate 26 by conductor 36. Power for the entire electrical short locator is supplied by power supply 5.

The short locator is highly suited for detecting shorts at the time they are made, that is, during the process of adding leads 7 to terminals 6. In operation, the assembler connects conductors 19a—19n to bus bars 3a—3n, respectively, by connecting socket 9 to plugs 8, and closes power switch 16. When the power is on, a train of positive pulses is fed to ring counter 11. Each time a pulse enters counter 11, a positive pulse of equal duration is generated on a different counter output lead.

Leads 13a—13n receive the positive output pulses in sequential order. At any given time all counter output leads 13a—13n are grounded except one. The positive output pulses are channeled to the transistor bases and thus the transistors are sequentially biased into conduction and likewise the LED's are sequentially biased into conduction. That is, when a positive pulse emanates from counter 11 on lead 13a, transistor 12a and LED 14a simultaneously conduct for the duration of the positive pulse. As soon as these semiconductors stop conducting, semiconductors 12b and 14b conduct, and so forth. If oscillator 31 has a frequency of 1 Hz, the LED's will sequentially glow and each will glow for a period of 0.5 seconds.

The wiper 2.3 of potentiometer 10 is adjusted so that a reference voltage is produced on input 22 that is slightly greater than the voltage across resistor 18 (and at comparator input 25) when no bus bar short is present.

When two bus bars become shorted, the LED's stop conducting in sequence and the two particular LED's associated with the shorted bus bars continue to provide a visual indication until the short is removed or power switch 16 is opened. For example, when end 38 of lead 7 touches bus bar 3b and causes bus bar 3a to be shorted to bus bar 3b, the anode of LED 14b is connected to the anode of LED 14a. Consequently, when a positive pulse reaches the base of transistor 12a after the short occurs, LED's 14a and 14b both conduct and generate a visual indication. The current through resistors 16a and 16b also flows through resistor 18. With LED's 14a and 14b both conducting, the resulting current through resistor 18 produces a voltage drop across the resistor which exceeds the reference voltage on input 22 of comparator 21. The output of comparator 21 goes from ground potential to a positive potential and performs two tasks. It stops oscillator 31 (by switching the output of NOR gate 26 to ground potential) and it triggers one-shot multivibrator 35. The pulse from the multivibrator turns on alarm 32 for the duration of the pulse. Thus, as soon as the assembler hears alarm 32, he knows that a short has been created. By observing that LED's 14a and 14b are illuminated, the assembler knows that the short occurs between bus bas 3a and bus bar 3b. Without pulses from oscillator 31, the positive pulse originally applied to the base of transistor 12a by ring counter 11 will be extended indefinitely. Consequently, LED's 14a and 14b will remain illuminated until the short is discovered and removed. As soon as the short is removed, the current through resistor 18 will drop, the comparator output will swing to ground potential, oscillator 31 will start up, the LED's will again be sequentially illuminated, and the test circuit will once again be ready to detect an inadvertent short.

Transistors 12a—12n serve two useful functions. They amplify the LED currents and they protect the ring counter when a short occurs. Specifically, under a short circuit condition the transistors isolate a high-level counter output from a low-level output. Stated another way, the transistors prevent the grounding of the counter output with the positive voltage.

The invention is applicable to any electrical system involving complex wiring wherein it is desired to achieve real time discovery of wiring errors. When the number of buses or conductors is very large, the scanning rate can be increased by changing the values of resistors 28, 29 and capacitor 30 to increase the oscillator frequency.

The invention comprises test apparatus for locating electrical shorts that is especially suited for use while an electrical circuit is being fabricated or assembled. A ring counter 11 derives input pulses from a squarewave oscillator 31. The outputs of the counter are fed through transistors 12 to an array of light emitting diodes 14. Each diode is connected to an electrical conductor, such as a bus bar 3, to be tested. In the absence of a short between two electrical conductors, the diodes are sequentially illuminated. When a short occurs, a comparator/multivibrator circuit 21, 35 triggers an alarm 32 and stops the oscillator and the sequential energization of the diodes. The two diodes that remain illuminated identify the electrical conductors that are shorted. There is thus provided a real time electrical short locator that can quickly and reliably scan many bus bars, can operate from a low-voltage battery power supply, and has low power consumption.

## Claims

1. Apparatus for sensing and locating shorts between a plurality n of insulated electrical conductors, said apparatus comprising:
a plurality n of resistors (14a to 14n);
connection means (19a to 19n) for connecting a single electrode of each resistor to a different one of said electrical conductors;
sequencing means (31, 11, 12a to 12n) for sequentially energising said resistors;
an alarm (32); and
sensing means (18, 21, 10, 23, 35) for sensing the electric current passing through all of said resistors and for turning on said alarm and terminating said sequential energisation when a predetermined current level is exceeded, characterised in that: said resistors are respective electric lamps (14a to 14n); in that said sequencing means comprises pulse generator means (31) for generating pulses at a predetermined rate, means (11) having an input coupled to the output of said pulse generator means and n outputs for sequentially emitting pulses at said predetermined rate, and coupling means (12a to 12n) arranged sequentially to couple the n outputs to respective first terminals of said electric lamps; in that said sensing means comprises a resistor (18) connected between ground and second terminals of said electric lamps, a comparator (21) having first and second inputs (25, 22) and an output (36) the first input (25) being connected to the second terminals of said electric lamps, means (10, 23) for producing a fixed reference voltage and applying it to said second input of the comparator (21), and means (35) coupled to said output of said comparator (21) and connected to turn on said alarm for a predetermined period and to switch off said pulse generating means (31) when the voltage at said first input of the comparator exceeds said reference voltage; and in that said alarm is a sonic alarm (32), whereby said pulses from said pulse generator means (31) cause in operation said lamps to be sequentially energised at said predetermined rate and a maximum voltage V to be produced across said resistor (18) when no conductors are shorted together so that when said reference voltage is set slightly higher than V a short condition between at least two of said conductors will cause said voltage across said resistor (18) to exceed said reference voltage whereby said comparator will respond to cause said pulse generating means (31) to stop generating pulses, to cause said alarm to sound for said predetermined period, and to cause those electric lamps associated with the shorted conductors to remain illuminated until the short condition is removed.

2. Apparatus according to claim 1 wherein said means for sequentially emitting pulses is a ring counter (11).

3. Apparatus according to claim 1 or 2 wherein said means connected to turn on said alarm is a one-shot multivibrator (35).

4. Apparatus according to any one of claims 1 to 3 wherein said coupling means includes a plurality of transistor switches (12a to 12n) respectively controlled by said pulses from said n outputs.

## Patentansprüche

1. Einrichtung zum abfühlen und Orten von Kurzschlüssen unter n isolierten elektrischen Leitern mit
einer Mehrzahl n von Widerständen (14a ... 14n);
Verbindungsmitteln (19a ... 19n) zum Verbinden einer einzelnen Elektrode jedes Widerstands mit einem anderen der elektrischen Leiter;
Fortschaltmitteln (31, 11, 12a ... 12n) zum sequentiellen Einspeisen der Widerstände;
einer Alarmeinrichtung (32);
einer Abfühleinrichtung (18, 21, 10, 23, 35) zum Abfühlen des durch alle Widerstände fließenden elektrischen Stroms und zum Einschalten der Alarmeinrichtung und Beenden der sequentiellen Einspeisung, wenn ein vorbestimmter Strompegel überschritten wird, dadurch gekennzeichnet, daß die Widerstände entsprechende elektrische Lampen (14a bis 14n) sind, daß die Fortschaltmittel einen Impulsgenerator (31) zum Erzeugen von Impulsen mit einer vorbestimmten Geschwindigkeit, eine Einrichtung (11) mit einem Eingang, der mit dem Ausgang des Impulsgenerators gekoppelt ist, und mit n Ausgängen zum sequentiellen Abgeben von Impulsen mit der vorbestimmten Geschwindigkeit, und sequentiell angeordnete Koppelmittel (12a bis 12n) zum Koppeln der n Ausgänge an entsprechende erste Anschlüsse der elektrischen Lampen umfassen; daß die Abfühleinrichtung einen zwischen Masse und zweite Anschlüsse der elektrischen Lampen geschalteten Widerstand (18) einen erste und zweite Eingänge (25, 22) und einen Ausgang (36) aufweisenden Komparator (21), wobei der erste Eingang (25) mit den zweiten Anschlüssen der elektrischen Lampen verbunden ist, eine Einrichtung (10, 23) zum Erzeugen einer festen Referenzspannung und zum Zuführen dieser zu dem zweiten Eingang des Komparators (21), und eine mit dem Ausgang des Komparators (21) gekoppelte Einrichtung (35) umfaßt, die derart geschaltet ist, daß die Alarmeinrichtung für eine vorbestimmte Zeitdauer eingeschaltet und der Impulsgenerator (31) ausgeschaltet wird, wenn die Spannung an dem ersten Eingang des Komparators die Referenzspannung überschreitet; und daß die Alarmeinrichtung eine akustische Alarmeinrichtung (32) ist, wodurch die Impulse von dem Impulsgenerator (31) im Betrieb bewirken, daß die Lampen sequentiell mit der vorbestimmten Geschwindigkeit und einer maximalen über dem Widerstand (18) zu erzeugenden Spannung (V) eingespeist werden, wenn keine Leiter kurzgeschlossen sind, so daß, wenn die Bezugsspannung etwas höher als V eingestellt wird, ein Kurzschlußzustand zwischen wenigstens zwei der Leiter dazu führen wird, daß die Spannung über dem Widerstand (18) die Bezugsspannung übersteigt, wodurch der Komparator ansprechen und bewirken wird, daß der Impulsgenerator (31) mit dem Erzeugen von Impulsen aufhört, die Alarmeinrichtung während der vorbestimmten Zeitdauer ertönt und die den kurzgeschlossenen Leitern zugeordneten elektrischen Lampen beleuchtet bleiben, bis der Kurzschlußzustand beseitigt ist.

2. Einrichtung nach Anspruch 1, dadurch gekennzeichnet, daß die Einrichtung zum sequentiellen Abgeben von Impulsen ein Ringzähler (11) ist.

3. Einrichtung nach Anspruch 1 oder 2, dadurch gekennzeichnet, daß die zum Einschalten der Alarmeinrichtung geschaltete Einrichtung ein monostabiler Multivibrator (35) ist.

4. Einrichtung nach einem der Ansprüche 1 bis 3, dadurch gekennzeichnet, daß die Koppelmittel eine Mehrzahl von Transistorschaltern (12a bis 12n) aufweisen, die entsprechend durch die Impulse von den n Ausgängen gesteuert sind.

## Revendications

1. Appareil pour détecter et localiser des courtscircuits entre une pluralité n de conducteurs électriques isolés, comprenant:
une pluralité n de résistances (14a à 14n), des moyens de raccordement (19a à 19n) pour raccorder une unique borne de chaque résistance respectivement à un conducteur différent desdits conducteurs électriques, des moyens de balayage séquentiel (31, 11, 12a à 12n) pour alimenter séquentiellement ces résistances, un moyen d'alarme (32), des moyens de détection (18, 21, 10, 23, 35) pour détecter le courant électrique traversant toutes les résistances et pour mettre en action le moyen d'alarme et suspendre ladite alimentation séquentielle quand une valeur prédéterminée du courant est dépassée, caractérisé en ce que les résistances comprennent des lampes électriques respectives (14a à 14n), les moyens de balayage séquentiel comprennent un générateur d'impulsions (31) générant des impulsions à une fréquence prédéterminée, un moyen de distribution (11) ayant une entrée réunie à la sortie du générateur d'impulsions et n sorties pour l'émission séquentielle des impulsions à la fréquence prédéterminée, des moyens de raccordement (12a à 12n) disposés séquentiellement pour coupler les n sorties respectivement à une première borne des lampes électriques, cependant que les moyens de détection comprennent une résistance (18) branchée entre la masse et la seconde borne des mêmes lampes électriques, un comparateur (21) ayant une première et une seconde entrée (25, 22) et une sortie (36), la première entrée (25) étant raccordée à la seconde borne des lampes électriques, des moyens (10, 23) de production d'une tension fixe de référence et d'envoi de cette tension à une seconde entrée du comparateur (21), des moyens (35) raccordés à la sortie du comparateur (21) et aptes à mettre en action le moyen d'alarme pendant une durée prédéterminée et à arrêter le générateur d'impulsions (31) quand la tension à la première entrée du comparateur excède la tension de référence, le moyen d'alarme étant un moyen d'alarme sonore de sorte que les impulsions provenant du générateur d'impulsions (31) font que pendant le fonctionnement les lampes sont alimentées séquentiellement à la fréquence prédéterminée et une tension maximum V est produite aux bornes de la résistance (18) quand aucun des conducteurs ne sont en court-circuit ensemble si bien que lorsque la tension de référence est fixée à une valeur légèrement supérieure à V l'existence d'un court-circuit entre deux au moins des conducteurs a pour effet que la tension aux bornes de la résistance (18) surpasse la tension de référence et que le comparateur réagit en provoquant l'arrêt du générateur d'impulsions (31), en faisant résonner le moyen d'alarme pendant la durée prédéterminée et en tenant allumées les lampes électriques associées aux conducteurs en court-circuit jusqu'à ce que le court-circuit soit supprimé.

2. Appareil selon la revendication 1 caractérisé en ce que le moyen de l'émission séquentielle des impulsions est un compteur circulaire (11).

3. Appareil selon l'une quelconque des revendications 1, 2 caractérisé en ce que les moyens aptes à mettre en action le moyen d'alarme pendant une durée prédéterminée sont constitués par un multivibrateur monostable (35).

4. Appareil selon l'une quelconque des revendications 1 à 3 caractérisé en ce que les moyens de raccordement (12a à 12n) comprennent une pluralité de transistors (12a à 12n) commandés respectivement par les impulsions provenant des n sorties.

FIG. 1

FIG. 2